# EUROPEAN PATENT APPLICATION

(11) **EP 2 608 209 A1**
(43) Date of publication of application: **26.06.2013**
(21) Application number: 11194761.0
(22) Date of filing: 21.12.2011
(51) Int. Cl.: G11C 13/00, H01L 27/24

(54) **Resistive memory array**

(71) Applicant: IMEC, 3001 Leuven (BE)
(72) Inventor: Wouters, Dirk, 3001 Leuven (BE); Blomme, Pieter, 8400 Oostende (BE); Kar, Gouri Sankar, 3001 Leuven (BE)
(74) Representative: Hertoghe, Kris Angèle Louisa

(57) **Abstract**

A resistive memory array (10) comprises a plurality of resistive memory elements (11), a plurality of first lines (WLi) each associated with at least one resistive memory element (11), and arranged substantially in a first direction, a plurality of second lines (BLj) each associated with at least one resistive memory element (11), and arranged substantially in a second direction different from the first direction, and a plurality of third lines (CWLi) controlling conductivity of the plurality of first lines (WLi). The third lines for controlling conductivity of the plurality of first lines replace cell selectors as known in the art. The present invention also provides a method of manufacturing such resistive memory array (10).

## Description

### Field of the invention

The present invention relates to semiconductor memory devices, more particularly to arrays of non-volatile memory cells comprising a reversible resistance switching layer, their resistance value being representative of the data stored in the memory cell. The present invention in particular relates to a new array design for minimizing design area and to methods of fabrication thereof.

### Background of the invention

A resistive memory device, such as for example the electrically programmable resistive cross point memory device as described in US2003/0003674, is a non-volatile memory device which generally comprises an active layer capable of having its resistivity changed in response to an electrical signal, interposed between a plurality of conductive top and bottom electrodes. The active layer usually comprises a dielectric material, such as for example one or more metal oxide layers, a solid electrolyte material, a magnetic tunnel junction or a phase change material, which may be interposed between two conductive electrodes, for example wire-shaped Pt, W or TiN electrodes. At a cross point of a top electrode and a bottom electrode, a cross point referring to each position where a top electrode crosses a bottom electrode, the active layer has a programmable region with a resistivity that can change in response to an applied voltage. The memory effect of the resistive memory device lies in the programming of the memory device into two distinct resistive states..

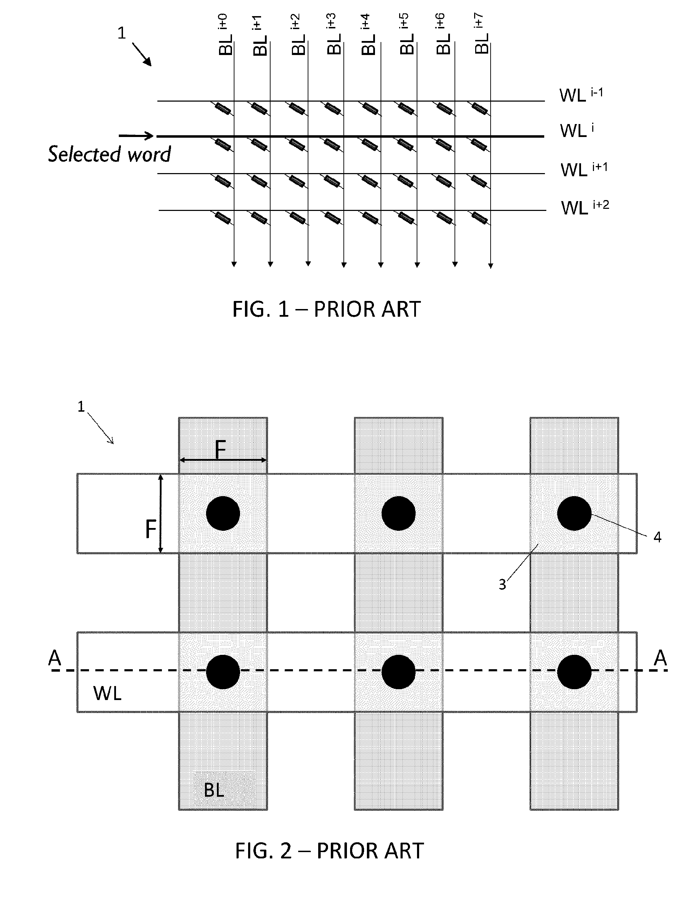

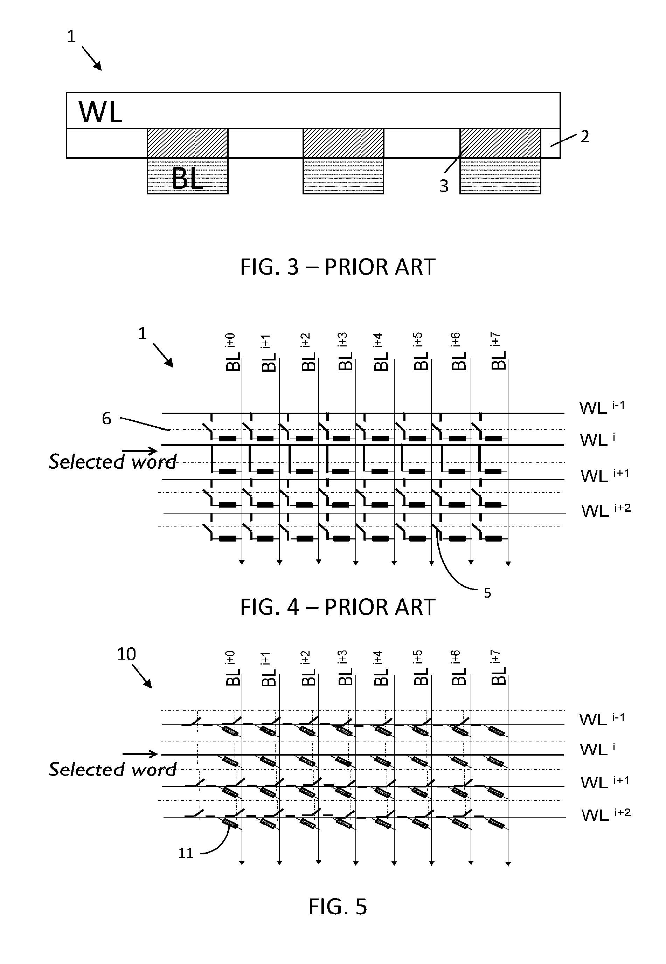

A resistive memory array, comprising a plurality of resistive memory elements, typically comprises a cross-bar array of top and bottom electrodes as illustrated schematically in FIG. 1, in top view in FIG. 2, and in cross-section in FIG.3. The resistive memory device 1 comprises a plurality of top electrodes (e.g. wordlines WL) and a plurality of bottom electrodes (e.g. bit lines BL) which, together with an active layer 2 between the top and bottom electrodes, form a plurality of cross-point memory elements. The active layer 2 is interposed between the plurality of wordlines WL and bit lines BL. At each crossing of a wordline WL with a bit line BL, a programmable region, i.e. a bit 3, is formed in the active layer 2. The resistivity of the bit 3 can be changed for example due to filament formation or filament disruption in response to a voltage or current applied between the corresponding wordline WL and the bit line BL. The position of the filaments are schematically indicated with closed circles 4 in FIG. 2. Supposing that the world lines WL and the bit lines BL each have a width F being the minimum width obtainable with a given technology, the density of the resistive memory device 1 as illustrated in FIG. 2 can be calculated to be 1 filament/4F², thus 1 bit/4F².

Such raw cross-point arrays with single RRAM elements lead to a large parasitic current flowing through non-selected memory cells. Hence raw cross-point arrays suffer from READ errors (sneak currents) and possibly from PROGRAM errors, as well as from excessive current and power consumption.

One solution to alleviate these problems is to put a selector 5 in each cell, as illustrated in FIG. 4. Ideally this can be a transistor, requiring the addition of another control wordline 6, but also a (bipolar) diode/switch device has been proposed as a selector 5. Examples of resistive memory arrays comprising memory cells including selection transistors are given in US2009/014836.

Disadvantages of solutions including a selector 5 in each cell are the increase of the cell size, hence the reduced memory density, the more complex processing - not a simple cross-point array but requiring the definition of intermediate pillar elements -, and the fact that no appropriate 2D terminal bipolar selector devices have been identified - bipolar devices require less chip area than MOS devices but are less process friendly.

Accordingly, there is room for new structures and processing methods for manufacturing non-volatile memory cells, which allow a high cell density.

### Summary of the invention

It is an object of embodiments of the present invention to provide high density non-volatile resistive memory arrays having limited READ and/or PROGRAM errors.

The above objective is accomplished by a method and device according to the present invention.

In a first aspect, the present invention provides a resistive memory array comprising a plurality of resistive memory elements, a plurality of first lines each associated with at least one resistive memory element and arranged substantially in a first direction, a plurality of second lines each associated with at least one resistive memory element and arranged substantially in a second direction different from the first direction, and a plurality of third lines for controlling conductivity of the plurality of first lines. It is an advantage of a resistive memory array according to embodiments of the present invention that no selector needs to be provided in each cell, hence that small cell sizes may be obtained.

The plurality of third lines may be arranged in the first direction. This way they can more easily influence the conductivity of the plurality of first lines in a transistor-like manner. In particular embodiments of the present invention, the plurality of third lines may overlay the plurality of first lines or vice versa.

In a resistive memory array according to embodiments of the present invention, the first direction and the second direction may be substantially orthogonal directions. In alternative embodiments, the first direction and the second direction may be along circles and radii of these circles, respectively, or vice versa.

Any third line may be associated with one of the first lines.

In a resistive memory array according to embodiments of the present invention, a conductive electrode layer may be provided between the resistive memory elements and the first lines.

In a resistive memory array according to embodiments of the present invention, the memory elements may be logically arranged in rows and columns, in a 2D configuration. In alternative embodiments, the memory elements may be logically arranged in stacks of rows and columns, in a 3D configuration.

In a resistive memory array according to embodiments of the present invention, the resistive memory array being manufactured on a substrate having a major surface, the first lines and the second lines may both be arranged parallel to the major surface. A plurality of layers comprising first lines and second lines may be stacked in a direction perpendicular to the major surface, so as to obtain a 3D structure.

In a resistive memory array according to alternative embodiments of the present invention, the first lines may be arranged parallel to the wafer surface, and the second lines may be arranged substantially perpendicular to the major surface, or vice versa. Also this way, a 3D structure is obtained.

In a second aspect, the present invention provides a method of manufacturing a resistive memory array. The method comprises providing a plurality of resistive memory elements, providing a plurality of first lines each associated with at least one resistive memory element and arranged substantially in a first direction, providing a plurality of second lines each associated with at least one resistive memory element and arranged substantially in a second direction different from the first direction, and providing a plurality of third lines for controlling conductivity of the plurality of first lines.

In a method according to embodiments of the present invention, providing a plurality of first lines may comprise providing the plurality of first lines in a plane parallel to a major surface of a substrate and providing a plurality of second lines may comprise providing the plurality of second lines in a plane parallel to the major surface of the substrate. This way, a 2D configuration is provided.

In a method according to alternative embodiments of the present invention, providing a plurality of first lines may comprise providing the plurality of first lines in a plane parallel to a major surface of a substrate and providing a plurality of second lines may comprise providing the plurality of second lines substantially perpendicular to the major surface of the substrate. This way, a 3D configuration is provided.

In a method according to yet alternative embodiments of the present invention, providing a plurality of first lines may comprise providing the plurality of first lines substantially perpendicular to the major surface of the substrate and providing a plurality of second lines may comprise providing the plurality of second lines in a plane parallel to a major surface of a substrate. Also this way a 3D configuration is provided.

It is an advantage of embodiments of the present invention that cells with the smallest cell size in a raw cross-point array can be realized, thereby, however, reducing sneak currents compared to a prior art raw cross-point array, or even avoiding these.

Particular and preferred aspects of the invention are set out in the accompanying independent and dependent claims. Features from the dependent claims may be combined with features of the independent claims and with features of other dependent claims as appropriate and not merely as explicitly set out in the claims.

For purposes of summarizing the invention and the advantages achieved over the prior art, certain objects and advantages of the invention have been described herein above. Of course, it is to be understood that not necessarily all such objects or advantages may be achieved in accordance with any particular embodiment of the invention. Thus, for example, those skilled in the art will recognize that the invention may be embodied or carried out in a manner that achieves or optimizes one advantage or group of advantages as taught herein without necessarily achieving other objects or advantages as may be taught or suggested herein.

The above and other aspects of the invention will be apparent from and elucidated with reference to the embodiment(s) described hereinafter.

### Brief description of the drawings

The invention will now be described further, by way of example, with reference to the accompanying drawings, in which:
FIG. 1 is a schematic illustration of a prior art resistive memory raw cross-point array with a cross-bar array configuration of the top electrodes and the bottom electrodes.
FIG. 2 is a top view of a portion of a prior art resistive memory array as in FIG. 1.
FIG. 3 is a cross-sectional view of the portion of a prior art resistive memory array of FIG. 2, taken along section A-A in FIG. 2. The shaded zones are the programmable regions in the active layer with changeable resistivity.
FIG. 4 is a schematic illustration of a prior art resistive memory array including a selector in each memory cell.
FIG. 5 is a schematic illustration of a resistive memory array including a selector integrated in a wordline in accordance with embodiments of the present invention.
FIG. 6 is a vertical cross-section of a first embodiment of a resistive memory array in a 2D configuration according to the present invention, where the bitlines are provided at the bottom and the wordlines and control wordlines are provided at the top, and where no intermediate electrode is provided between the wordlines and the resistive memory elements.
FIG. 7 is a vertical cross-section of a second embodiment of a resistive memory array in a 2D configuration according to the present invention, where the wordlines and control wordlines are provided at the bottom and the bitlines are provided at the top, and where no intermediate electrode is provided between the wordlines and the resistive memory elements.
FIG.8 and FIG.9 illustrate a third embodiment of a resistive memory array in a 2D configuration, where conductive material is provided between the wordlines and the resistive memory elements. In this third embodiment, bitlines are provided at the top, and the wordlines and control wordlines are provided at the bottom.
FIG. 10 illustrates a vertical cross-sectional view of a basic part of a resistive memory array in a 3D configuration according to a fifth embodiment of the present invention, which is a plug version without intermediate electrode between the wordline and the resistive memory element. A complete array comprises a plurality of such basic parts that are connected like for example depicted in FIG. 21.
FIG. 11 is a top view of the memory array of FIG. 10.
FIG. 12 illustrates yet another vertical cross-sectional view of a resistive memory array in a 3D configuration according to embodiments of the present invention.
FIG. 13 to FIG. 20 illustrate different steps in a process flow for manufacturing a resistive memory array in a 3D configuration according to embodiments of the present invention. The 3D configuration manufactured according to this flow is a resistive memory array according to a seventh embodiment of the present invention, which is a trench version without intermediate electrode between wordlines and resistive memory material.
FIG. 21 illustrates a memory array according to the seventh embodiment of the present invention (3D trench version without intermediate electrode between wordlines and resistive memory material), with interrupted bitlines between neighboring wordlines.
FIG. 22 illustrates a memory array according to an eighth embodiment of the present invention, which is a 3D trench version without intermediate electrode between wordlines and resistive memory material, but with continuous bitlines between neighboring wordlines.
FIG. 23 illustrates a top view of the array of FIG. 22.
FIG. 24 to FIG. 31 illustrate different steps in a process flow for manufacturing a resistive memory array in a 3D configuration according to a ninth embodiment of the present invention. The resistive memory array is of a 3D trench type, with bitlines vertical and without intermediate electrode between the wordlines and the resistive material.
FIG. 32 to FIG. 34 illustrate different steps in a process flow for manufacturing a resistive memory array in a 3D configuration according to a tenth embodiment of the present invention. The resistive memory array is of a 3D trench type, with intermediate electrode between the wordlines and the resistive material.

The drawings are only schematic and are non-limiting. In the drawings, the size of some of the elements may be exaggerated and not drawn on scale for illustrative purposes. The dimensions and the relative dimensions do not necessarily correspond to actual reductions to practice of the invention.

Any reference signs in the claims shall not be construed as limiting the scope.

In the different drawings, the same reference signs refer to the same or analogous elements.

### Detailed description of illustrative embodiments

The present invention will be described with respect to particular embodiments and with reference to certain drawings but the invention is not limited thereto but only by the claims.

The terms first, second and the like in the description and in the claims, are used for distinguishing between similar elements and not necessarily for describing a sequence, either temporally, spatially, in ranking or in any other manner. It is to be understood that the terms so used are interchangeable under appropriate circumstances and that the embodiments of the invention described herein are capable of operation in other sequences than described or illustrated herein.

Moreover, the terms top, under and the like in the description and the claims are used for descriptive purposes and not necessarily for describing relative positions. It is to be understood that the terms so used are interchangeable under appropriate circumstances and that the embodiments of the invention described herein are capable of operation in other orientations than described or illustrated herein.

It is to be noticed that the term "comprising", used in the claims, should not be interpreted as being restricted to the means listed thereafter; it does not exclude other elements or steps. It is thus to be interpreted as specifying the presence of the stated features, integers, steps or components as referred to, but does not preclude the presence or addition of one or more other features, integers, steps or components, or groups thereof. Thus, the scope of the expression "a device comprising means A and B" should not be limited to devices consisting only of components A and B. It means that with respect to the present invention, the only relevant components of the device are A and B.

Reference throughout this specification to "one embodiment" or "an embodiment" means that a particular feature, structure or characteristic described in connection with the embodiment is included in at least one embodiment of the present invention. Thus, appearances of the phrases "in one embodiment" or "in an embodiment" in various places throughout this specification are not necessarily all referring to the same embodiment, but may. Furthermore, the particular features, structures or characteristics may be combined in any suitable manner, as would be apparent to one of ordinary skill in the art from this disclosure, in one or more embodiments.

Similarly it should be appreciated that in the description of exemplary embodiments of the invention, various features of the invention are sometimes grouped together in a single embodiment, figure, or description thereof for the purpose of streamlining the disclosure and aiding in the understanding of one or more of the various inventive aspects. This method of disclosure, however, is not to be interpreted as reflecting an intention that the claimed invention requires more features than are expressly recited in each claim. Rather, as the following claims reflect, inventive aspects lie in less than all features of a single foregoing disclosed embodiment. Thus, the claims following the detailed description are hereby expressly incorporated into this detailed description, with each claim standing on its own as a separate embodiment of this invention.

Furthermore, while some embodiments described herein include some but not other features included in other embodiments, combinations of features of different embodiments are meant to be within the scope of the invention, and form different embodiments, as would be understood by those in the art. For example, in the following claims, any of the claimed embodiments can be used in any combination.

It should be noted that the use of particular terminology when describing certain features or aspects of the invention should not be taken to imply that the terminology is being re-defined herein to be restricted to include any specific characteristics of the features or aspects of the invention with which that terminology is associated.

In the description provided herein, numerous specific details are set forth. However, it is understood that embodiments of the invention may be practiced without these specific details. In other instances, well-known methods, structures and techniques have not been shown in detail in order not to obscure an understanding of this description.

In the context of the present invention, a resistive random-access memory (RRAM) is a non-volatile memory type having as basic idea that a dielectric, which is normally insulating, can be made to conduct through a filament or conduction path formed after application of a sufficiently high voltage. Once the filament is formed, it may be reset (broken, resulting in high resistance) or set (reformed, resulting in lower resistance) by an appropriately applied voltage.

In a raw cross-point cell, a pure RRAM memory element is used as a basic memory cell, resulting in a configuration where parallel bitlines are crossed by perpendicular wordlines with the switching material placed between wordline and bitline at every cross-point. In this architecture, large parasitic currents flow through non-selected memory cells.

FIG. 5 schematically illustrates a portion of a resistive memory array 10 according to embodiments of the present invention. The resistive memory array 10 comprises a plurality of resistive memory elements 11 logically arranged in rows and columns. Throughout this description, the terms "horizontal" and "vertical" (related to the terms "row" and "column" respectively) are used to provide a co-ordinate system and for ease of explanation only. They do not need to, but may, refer to an actual physical direction of the device. Furthermore, the terms "column" and "row" are used to describe sets of array elements which are linked together. The linking can be in the form of a Cartesian array of rows and columns; however, the present invention is not limited thereto. As will be understood by those skilled in the art, columns and rows can be easily interchanged and it is intended in this disclosure that these terms be interchangeable. Also, non-Cartesian arrays may be constructed and are included within the scope of the invention. Accordingly the terms "row" and "column" should be interpreted widely. To facilitate in this wide interpretation, the claims refer to logically organised in rows and columns. By this is meant that sets of memory elements are linked together in a topologically linear intersecting manner; however, that the physical or topographical arrangement need not be so. For example, the rows may be circles and the columns radii of these circles and the circles and radii are described in this invention as "logically organized" rows and columns.

The resistive memory array 10 furthermore comprises a plurality of wordlines WLᵢ arranged in the direction of the rows of memory elements 11, and a plurality of bitlines BLⱼ arranged in the direction of the columns of memory elements 11, or vice versa. In particular embodiments, where the wordlines WLᵢ and the bitlines BLⱼ are arranged in the form of a Cartesian array, the wordlines WLᵢ are parallel to one another, and the bitlines BLⱼ are parallel to one another. The wordlines WLᵢ may be arranged perpendicular to the bitlines BLⱼ. In alternative embodiments, the wordlines WLᵢ may be arranged as concentric circles and the bitlines BLⱼ may be arranged as radii of these circles, or vice versa. Specific names of the various lines, e.g. wordline and bitline, are intended to be generic names used to facilitate the explanation and to refer to a particular function and this specific choice of words is not intended to in any way limit the invention. It should be understood that all these terms are used only to facilitate a better understanding of the specific structure being described, and are in no way intended to limit the invention.

In accordance with embodiments of the present invention, the wordlines WLᵢ are implemented as a select device. This means that, instead of putting a selector in each cell, as is done in prior art solutions, in accordance with embodiments of the present invention, the wordlines can be made conducting or non-conducting (switched on or off). Hereto, a control line is provided adjacent the wordlines, e.g. on top of the wordlines if the wordlines are placed above the bitlines in parallel planes or below the wordlines if the wordlines are placed below the bitlines in parallel planes, or adjacent the wordlines in a vertical layout in a configuration where bitlines are laid out in parallel planes, and wordlines are laid out perpendicular to the plane of the bitlines, as will be detailed below.

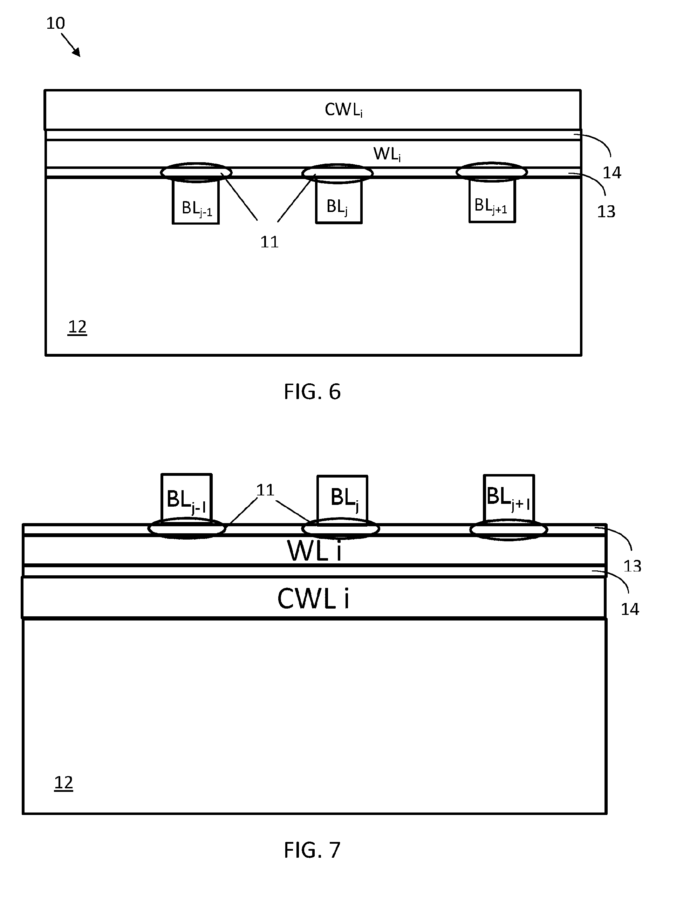

In a first embodiment, as illustrated in a cross-sectional view in FIG. 6, a resistive memory array 10 is proposed, where wordlines WLi are laid out in a first plane, and bitlines BLj are laid out in a second plane parallel to the first plane. A method of manufacturing may be as follows.

First, a substrate 12 is provided. In embodiments of the present invention, the term "substrate" may include any underlying material or materials that may be used, or upon which a device according to embodiments of the present invention may be formed. In alternative embodiments, this "substrate" may include a semiconductor substrate such as e.g. a silicon, a gallium arsenide (GaAs), a gallium arsenide phosphide (GaAsP), an indium phosphide (InP), a germanium (Ge), or a silicon germanium (SiGe) substrate. The "substrate" may include, for example, an insulating layer such as a SiO₂ or a Si₃N₄ layer in addition to a semiconductor substrate portion. Thus, the term substrate also includes silicon-on-glass, silicon-on sapphire substrates. The term "substrate" is thus used to define generally the elements for layers that underlie a layer or portions of interest. Also, the "substrate" may be any other base on which a layer is formed, for example a glass or metal layer. As examples, the substrate 12 may be made of any suitable material, whether amorphous, polycrystalline or crystalline, such as LaAlO₃, Si, TiN or other material.

On or in a major surface of the substrate 12, a plurality of bitlines BLⱼ₋₁, BLⱼ, BLⱼ₊₁ are provided. The bitlines are made of conductive material including metals, e.g. poly-silicon, TiSiC, C, TiW, SiC, Ti, V, W, Cr, Fe, Ni, Nb, Pd, Pt, Zr, Mo, Cu, Al, Ag, Au, Hf and alloys thereof; conductive oxides e.g. IrO₂, RuO₂, IrRuO₃, LiNbO₃; metal nitrides, e.g. TiAlN, TiN, TaN, TiSiN, TiCN, TaSiN, MoN, TaAlN, WN; metal silicides e.g. TiSix, NiSix, CoSix; or combinations of any of the above. In particular embodiments, the conductive material is a material such as YBa₂Cu₃O₇ (YBCO) that allows the epitaxial growth of an overlying perovskite material. The bitlines have a thickness in the range of between about 5 nm and about 500 nm. In particular embodiments, the bitlines may be formed by forming a trench in the substrate 112, depositing the conductive material and polishing the conductive material until level with the substrate 12. The polishing can be accomplished using chemical mechanical polishing (CMP) or other suitable means. Alternatively, the bitlines may be deposited and patterned without first forming a trench and without polishing.

An active layer 13 is deposited overlying the plurality of bitlines BLⱼ. The active layer 13 is made of a material capable of having its resistivity changed in response to an electrical signal. The active material may be a metal oxide (binary oxides from transition metals as NiO, HfO, TaO, ZrO, AIO, NbO, TiO, ...), optionally with a metallic cap layer (Hf, Ti, Al, Zr, ...) on one side, or complex oxides such as PrCaMnO (PCMO), or (doped) perovskite oxides, for example Cr:SrTi03, or it can be a solid electrolyte layer with incorporated Al or Cu, such as Cu(Al) Selenides or Tellerium compounds, or it can be combinations of multilayer stacks of different of the above layers combined. Alternatively, it can be phase change materials as e.g. GeSbTe, doped SbTe, or AsInSbTe. The active layer 13 may for example have a thickness between 5 nm and 500 nm. The active layer 13 can be deposited using any suitable deposition technique, including pulsed laser deposition, rf-sputtering, e-beam evaporation, thermal evaporation, atomic layer deposition, sol gel deposition, chemical vapour deposition. The active layer material is deposited over substantially the complete surface of the substrate 12, and is removed from outside the memory area by ion milling or any other suitable process. Alternatively it is also possible to form a large recess to thereover deposit active layer material, and then use a technique such as chemical mechanical polishing (CMP) to form the active layer 13.

A plurality of wordlines WLᵢ, of which only one is visible in the cross-sectional view of FIG. 6, overly the active layer 13, such that the active layer 13 is interposed between the bitlines BLⱼ and the wordlines WLᵢ. The wordlines are made of material of which the conductivity can be controlled, such as semiconductor material, e.g. silicon or poly-silicon or other suitable semiconductor materials. The doping concentration of the wordlines is limited by the need to be able to completely deplete it. The wordlines may be formed by depositing the suitable material, and patterning it so as to form the wordlines WLᵢ. Wordlines WLᵢ, as bitlines BLⱼ, may be present also outside the memory area, i.e. outside the area where active layer material 13 is present.

The wordlines WLᵢ and the bitlines BLⱼ are each for example substantially parallel rows. The wordlines WLᵢ and the bitlines BLⱼ are arranged in a cross point arrangement such that they cross each other in a regular pattern. A cross point refers to each position where a wordline WLᵢ crosses a bitline BLⱼ. As shown in the embodiment illustrated in FIG. 6, the wordlines WLᵢ and the bitlines BLⱼ are arranged at substantially 90 degrees with respect to one another. The resistive memory elements 11 are formed at the cross points between the wordlines WLᵢ and the bitlines BLⱼ.

In accordance with embodiments of the present invention, a dielectric layer 14 is provided over of the wordlines WLᵢ. This layer can be made of any suitable dielectric material, such as for example Si02 or HfO₂. The dielectric material 14 functions as a gate dielectric. The dielectric layer 14 may be patterned or not, but should remain present at least between the wordlines WLᵢ and the control lines CWLᵢ to be formed.

Over the layer 14 of dielectric material, a plurality of control lines CWLᵢ are provided, one control line associated with each wordline. The control lines CWLᵢ are aligned with their associated wordlines WLᵢ. The control lines CWLᵢ are made of conductive material, e.g. any of the conductive materials suitable for forming the bitlines BLⱼ, such as for example highly doped polysilicon. If semiconductor material is used for the control wordlines, the dopant concentration of this semiconductor material may be higher than the dopant concentration of the wordlines. The control lines CWLᵢ, when actuated, control the conductivity of the wordline WLᵢ they are associated with. By making non-selected wordlines WLᵢ non-conductive, sneak currents are dramatically reduced.

In a second embodiment, as illustrated in FIG. 7, an inverse configuration is provided: where in FIG. 6 the bitlines BLⱼ are present underneath the wordlines WLᵢ, in the embodiment of FIG. 7 the bitlines BLⱼ are present on top of the wordlines WLᵢ.

Materials used for the different layers may be similar or the same as the ones used and indicated with reference to the embodiment of FIG. 6. Only the manufacturing method is different. In this embodiment, first a substrate 12 is provided. On or in a major surface of the substrate 12, a plurality of control lines CWLᵢ are provided. In the cross-sectional view of FIG. 7, only one control line CWLᵢ can be seen, but other control lines are provided in front of and/or behind this control line CWLᵢ. In this embodiment, all control lines are placed in a plane substantially parallel to the plane of the major surface of the substrate, and the individual control lines CWLᵢ are placed substantially parallel with one another. The control lines may be manufactured in a trench, by process steps as explained with respect to the bitlines BLⱼ of the embodiment of FIG. 6. Alternatively, the control lines CWLᵢ may be deposited and patterned on top of the major surface of the substrate 12; without first forming a trench in the substrate 12.

A dielectric layer 14 is provided over of the control lines CWLᵢ. This layer functions as a gate dielectric. The dielectric layer 14 may be patterned or not, but should remain present at least between the control lines CWLᵢ and the wordlines WLᵢ to be formed.

Over the layer 14 of dielectric material, a plurality of wordlines WLᵢ are provided, one wordline WLᵢ associated with each control line CWLᵢ. The wordlines WLᵢ are aligned with their associated control lines CWLᵢ. The control lines CWLᵢ, when actuated, may control the conductivity of their associated wordlines WLᵢ. By making non-selected wordlines WLᵢ non-conductive, sneak currents are dramatically reduced.

An active layer 13 is deposited overlying the plurality of wordlines WLᵢ which may be provided with or without planarization process such as dielectric filling or CMP. The active layer 13 is made of a material capable of having its resistivity changed in response to an electrical signal. The active layer 13 may for example have a thickness between 5 nm and 500 nm. The active layer 13 can be deposited using any suitable deposition technique, including pulsed laser deposition, rf-sputtering, e-beam evaporation, thermal evaporation, atomic layer deposition, sol gel deposition, chemical vapour deposition. The active layer material may be deposited over substantially the complete surface of the substrate 12, and removed from outside the memory area by wet or dry etching or any other suitable process. Alternatively it is also possible to form a large recess to thereover deposit active layer material, and then use a technique such as chemical mechanical polishing (CMP) to form the active layer 13.

Bitlines BLⱼ are provided on top of the active layer 13, such that the active layer 13 is interposed between the bitlines BLⱼ and the wordlines WLᵢ. The wordlines WLᵢ and the bitlines BLⱼ are each for example substantially parallel rows. The wordlines WLᵢ and the bitlines BLⱼ are arranged in a cross point arrangement such that they cross each other in a regular pattern. A cross point refers to each position where a wordline WLᵢ crosses a bitline BLⱼ. As shown in the embodiment illustrated in FIG. 7, the wordlines WLᵢ and the bitlines BLⱼ are arranged at substantially 90 degrees with respect to one another. The resistive memory elements 11 are formed at the cross points between the wordlines WLᵢ and the bitlines BLⱼ. Both wordlines WLᵢ and bitlines BLⱼ may be present also outside the memory area, i.e. outside the area where active layer material 13 is present.

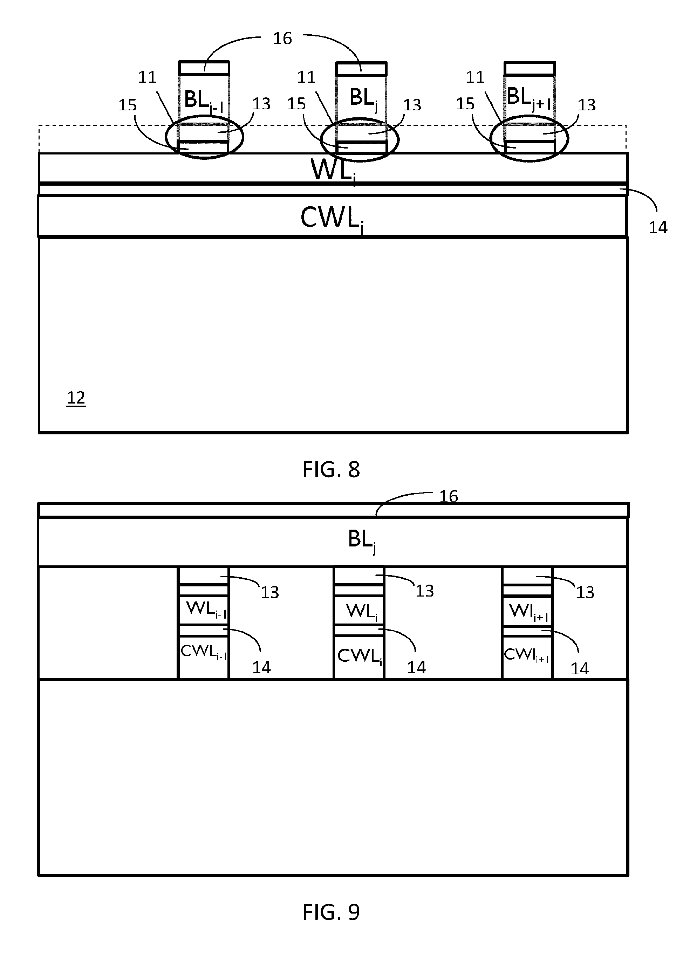

In accordance with a third embodiment of the present invention, e.g. applicable in the configurations illustrated in FIG. 6 and FIG. 7, a conductive electrode 15, for example a metal electrode, such as for example a TiN electrode can be provided between the layer of switching material 13 and the wordlines WLᵢ. This may improve programming characteristics of the device, in particular if the wordline material is not a good electrode material, such as e.g. poly. This is illustrated in FIG. 8 and FIG. 9 (vertical cross-sections in two substantially orthogonal directions), only for a third embodiment, corresponding to the configuration as in FIG. 7 provided with a supplementary conductive electrode between the wordlines and the layer of switching material, i.e. with bitlines BLⱼ on top of wordlines WLᵢ, but it will be clear for a person skilled in the art that this can also be applied to a fourth embodiment (not illustrated in the drawings) which is a configuration where the wordlines WLᵢ are provided on top of the bitlines BLⱼ as in FIG. 6, but with a supplementary conductive electrode between the wordlines and the layer of switching material.

This conductive electrode 15 is a region of small dimensions, substantially equal to the dimensions of the cross points between wordlines WLᵢ and bitlines BLⱼ. It may be manufactured by first, before forming the layer of resistive switching material, depositing a layer of conductive electrode material, e.g. metal, over the wordlines WLᵢ already manufactured, and etching it back in between the wordlines WLᵢ. This way, stripes of conductive electrode material, e.g. metal, are provided over the wordlines WLᵢ. Thereafter, the layer of resistive switching material is provided over the wordlines WLᵢ with stripes of conductive electrode material, e.g. metal, on top of which the bitlines BLⱼ are formed. In the process of forming the bitlines BLⱼ an etching step takes place for defining lines in the direction of columns of resistive memory elements 11. During this etching step, also the layer of resistive switching material and the layer of conductive electrode material between this layer of resistive switching material and the wordlines WLᵢ are etched. Hence the layer of conductive electrode material is removed in between the bitlines BLⱼ and in between the wordlines WLᵢ, so that conductive electrodes 15 only remain at cross points of wordlines WLᵢ and bitlines BLⱼ.

If the inverse configuration is manufactured, with wordlines WLᵢ on top of bitlines BLⱼ, the layer of conductive electrode material is first etched to form stripes parallel with and overlying the bitlines BLⱼ. Thereafter, during formation of the wordlines WLᵢ, the layer of conductive electrode material is etched once again so as to remove electrode material remaining in between wordlines WLᵢ. Also here conductive electrodes 15 only remain at cross points of wordlines WLᵢ and bitlines BLⱼ. In this case, the resistive switching layer does not necessarily need to be patterned so as to be present only at cross points between wordlines WLᵢ and bitlines BLⱼ.

In embodiments of the present invention, a further conductive electrode 16, for example e metal electrode such as e.g. a TiN electrode, may be present on top of (third embodiment, see FIG. 8 and 9) or underneath (fourth embodiment, configuration as in FIG. 6, but not illustrated) the bitlines BLⱼ. This further conductive electrode 16 may improve the electrical contact to the bitlines BLⱼ.

The above embodiments are embodiments where both wordlines WLᵢ and bitlines BLⱼ are provided both in a direction substantially parallel, e.g. parallel, to a major surface of the substrate 12. These are called 2D embodiments in the context of the present invention. In alternative embodiments, the bitlines BLⱼ may be provided substantially parallel, e.g. parallel, to a major surface of the substrate 12, and the wordlines WLᵢ may be provided substantially perpendicular, e.g. perpendicular, to the major surface of the substrate 12, or the wordlines WLᵢ may be provided substantially parallel, e.g. parallel, to a major surface of the substrate 12, and the bitlines BLⱼ may be provided substantially perpendicular, e.g. perpendicular, to the major surface of the substrate 12. These are called 3D embodiments in the context of the present invention, and they are explained hereinbelow.

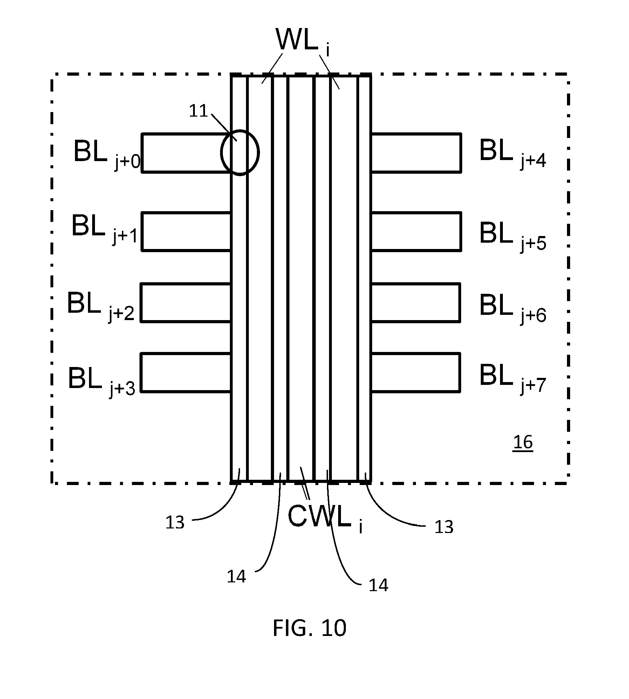

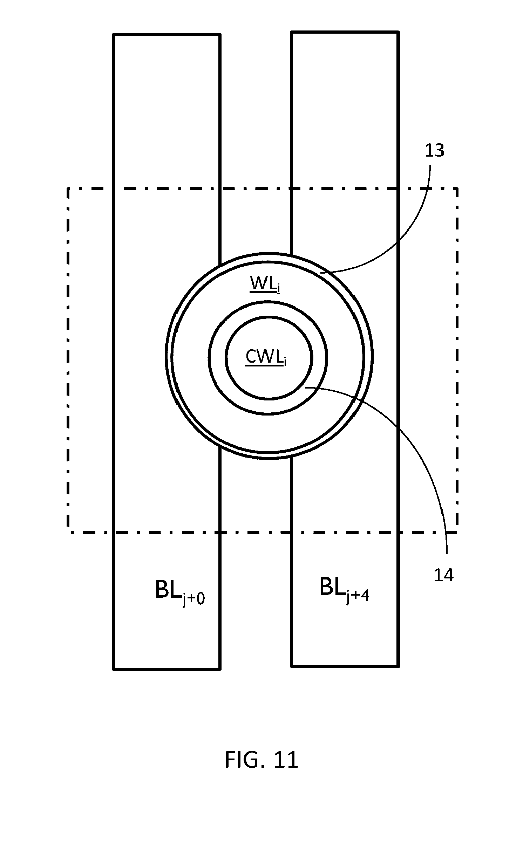

A fifth embodiment of the present invention, which is a first embodiment of a 3D configuration, is shown in side view in FIG. 10 and in top view in FIG. 11. This is a 3D plug version of the resistive memory array, without intermediate electrode between wordline and resistive switching material. In an alternative sixth embodiment, not illustrated in the drawings, a similar 3D plug version of the resistive memory array can be provided, which is with intermediate electrode between wordline and resistive switching material.

As can be seen in the illustrations of the fifth embodiment, substantially parallel or parallel to a major surface of a substrate (not illustrated), a plurality of bitlines BLⱼ are stacked. FIG. 10 and FIG. 11 illustrate one block of memory elements 11 which is repeated throughout a memory array 10. In the embodiment illustrated, bitlines BLⱼ and BLⱼ₊₄ are provided adjacent one another substantially parallel, e.g. parallel, to the major surface of the substrate, thus forming a level of bitlines, and such levels of bitlines are stacked onto one another in a direction perpendicular to the substrate. A stack of at least two levels of bitlines may be made. The levels of bitlines are separated from one another by dielectric material. In the embodiment illustrated, a stack of four levels of bitlines is made, the invention, however, not being limited thereto. Perpendicularly through the stack of bitlines, the wordlines WLᵢ and the control wordlines CWLᵢ are provided. This may be obtained by providing a rolled-up stack (plug) of control wordline CWLi, dielectric material 14, wordline WLi and active switching material 13. This rolled-up stack is filled in a hole etched through the dielectric material 16 and the different bitlines BLⱼ. This may be done by subsequently filling the hole with the relevant material and removing part of this material so as to make a new hole, to be filled with the next relevant material. The order of filling is active layer material, wordline material, dielectric material, control line material. In case of the sixth embodiment, a layer of electrode material is provided between the active layer material and the wordline material.

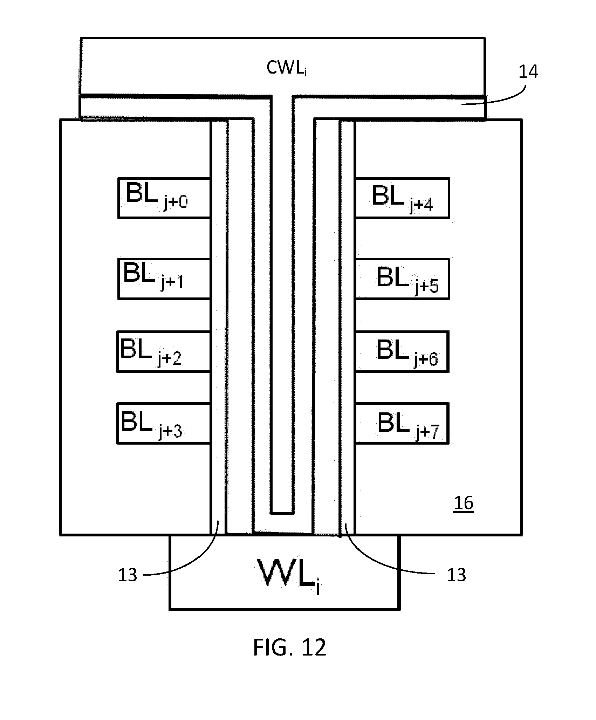

Once this plug is provided, connections to the wordline material and to the control wordline material need to be made, so as to enable access for driving the wordlines and control wordlines. As an example, connections to the wordline material may be made from the bottom, via a wordline WLᵢ, and connections to the control wordline material may be made from the top, via a control wordline CWLᵢ. This is illustrated in FIG. 12. Hereto, only the active layer 13 needs to be opened at the bottom side, e.g. by etching. Optionally, the wordline material may also be opened at the bottom side. Wordline material is removed at the top side between the vertical stacks. In alternative embodiments, not illustrated in the drawings, connections to the wordline material may be made from the top, and connections to the control wordline material may be made from the bottom.

In embodiments of the present invention, a plug may be provided cutting through a stack of bitlines. Alternatively, as illustrated in FIG.11, a plug may be provided cutting through two neighbouring stacks of bitlines, for higher density of the memory array.

In FIG. 11, the illustrated plug is cylindrical, circular in cross-section parallel to a major surface of the substrate, but in alternative embodiments a square plug could be provided with similar functionality. In yet other embodiments, the plug could have any suitable shape in cross-section.

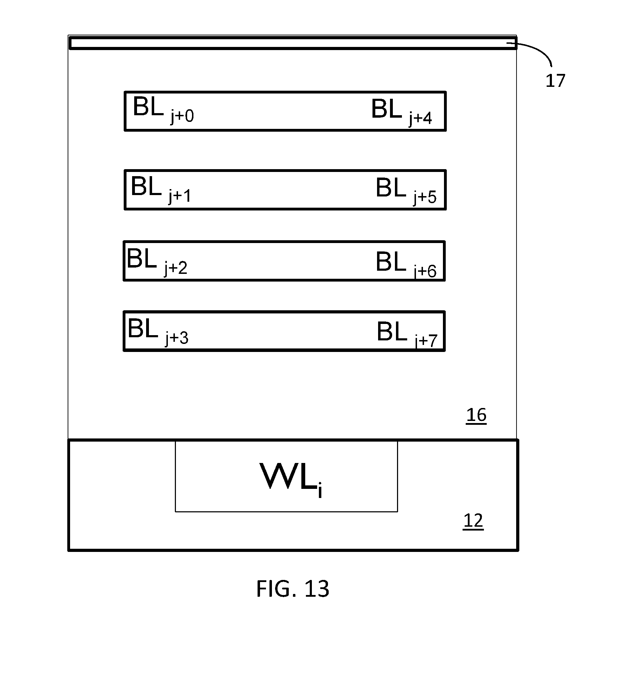

In alternative embodiments of the present invention, e.g. a seventh embodiment, rather than providing a plurality of plugs comprising the wordlines WLᵢ and control wordlines CWLᵢ, the wordlines and control wordlines can be provided in trenches. One method of manufacturing such 3D trench configuration is as follows, illustrated with respect to FIG. 13 to FIG. 17.

As illustrated in FIG. 13, on or in a substrate 12, at least one wordline WLᵢ is provided. The substrate 12 may be a substrate as disclosed with respect to the 2D embodiments. The wordline may be made from conductive material of which the conductivity can be controlled by applying a voltage to another line adjacent to the wordline, for example semiconductor material such as silicon or polysilicon. The doping concentration of the wordlines is limited by the need to be able to completely deplete it. On top of the wordlines WLᵢ, insulating material 16 is provided, such as e.g. SiO₂, SiN, and in the insulating material 16 layers of bitlines BLⱼ may be provided. The bitlines BLⱼ are made of conductive material, including metals, e.g. poly-silicon, TiSiC, C, TiW, SiC, Ti, V, W, Cr, Fe, Ni, Nb, Pd, Pt, Zr, Mo, Cu, Al, Ag, Au, Hf and alloys thereof; conductive oxides e.g. IrO₂, RuO₂, IrRuO₃, LiNbO₃; metal nitrides, e.g. TiAIN, TiN, TaN, TiSiN, TiCN, TaSiN, MoN, TaAIN, WN; metal silicides e.g. TiSix, NiSix, CoSix; or combinations of any of the above. Providing the stack of insulating material 16 and bitlines BLⱼ may be done by alternatingly depositing a layer of insulating material 16 and a layer of bitline material, so that the layers of bitline material are insulated from one another. The layers of bitline material are patterned such that in a layer of bitline material longitudinal bitlines BLⱼ are formed, substantially parallel to one another and substantially parallel to the major surface of the substrate 12. Insulating material 16 is provided on top of the upper level of bitlines BLⱼ. On top of the insulating material, an etch stop layer 17 may be provided, such as for example amorphous carbon (APF) or Silicon Nitride (Si₃N₄).

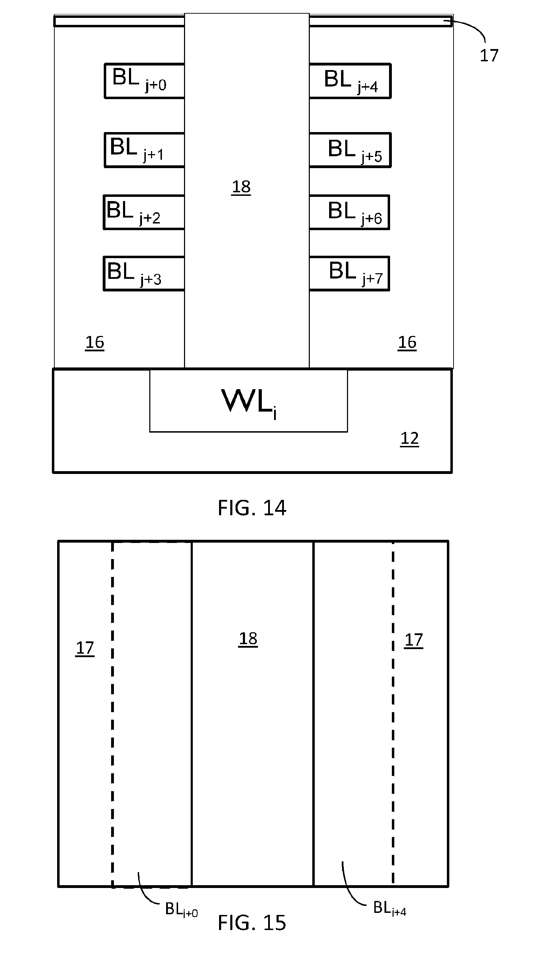

Once such stack is provided, a trench 18 is made through the stack of etch stop layer 17, insulating material 16 and bitlines BLⱼ, down to the wordline WLᵢ. This is illustrated in side view in FIG. 14 and in top view in FIG. 15.

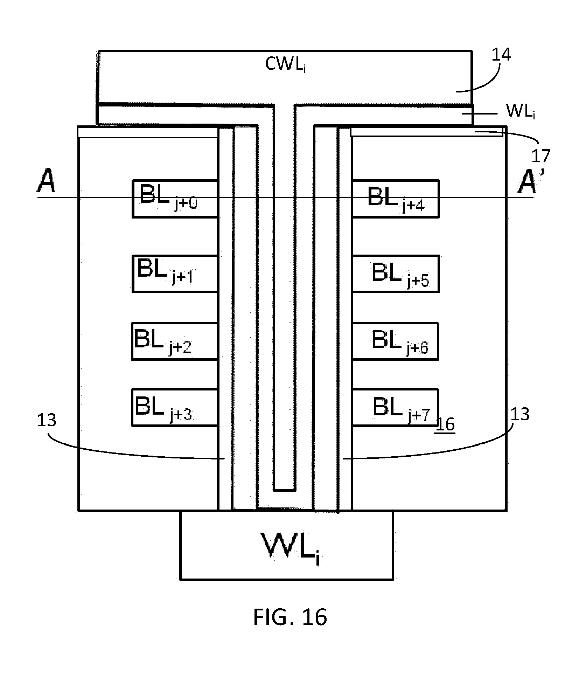

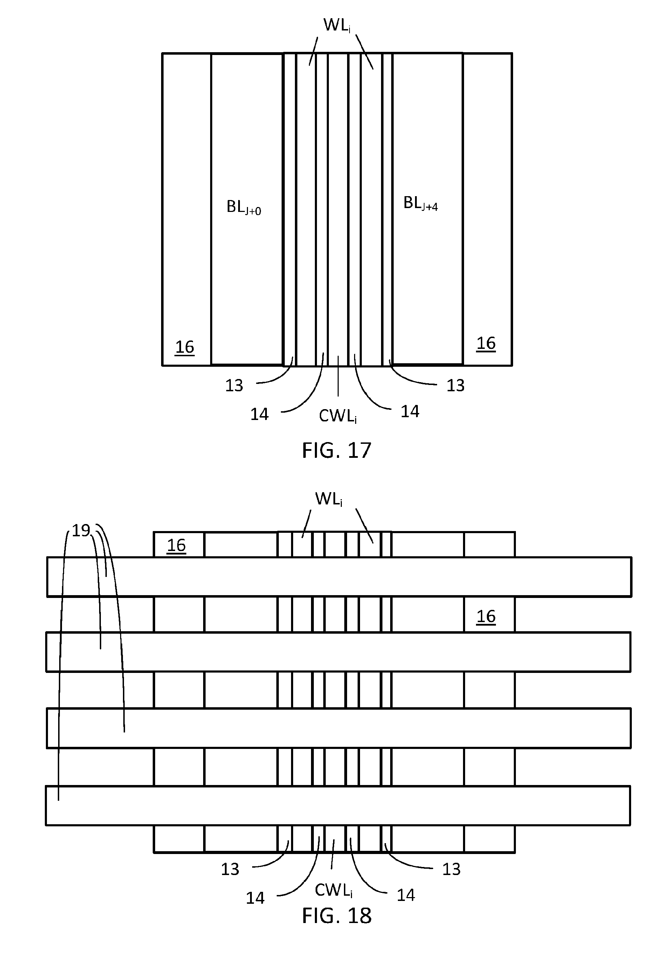

Thereafter, the trench 18 is filled with a stack of a control wordline CWLᵢ for controlling the conductivity of the wordline WLᵢ, a dielectric layer 14 functioning as gate insulator between the control wordline CWLi and the wordline WLi, the wordline WLi itself and active material 13 forming the switching layer. Such structure is illustrated in vertical cross-sectional view in FIG. 16, and in a top view at level AA' in FIG. 17. Suitable materials for those layers are indicated with respect to the 2D configurations.

Filling up the trench 18 with such stack as defined above may be obtained by subsequently depositing the different layers and etching them back. First a layer of active material 13, i.e. a material capable of having its resistivity changed in response to an electrical signal, is provided in the trench 18. The active material may be a metal oxide (binary oxides from transition metals as NiO, HfO, TaO, ZrO, AIO, NbO, TiO, ...), optionally with a metallic cap layer (Hf, Ti, Al, Zr, ...) on one side, or complex oxides such as PrCaMnO (PCMO), or (doped) perovskite oxides, for example Cr:SrTi03, or it can be a solid electrolyte layer with incorporated Al or Cu, such as Cu(Al) Selenides or Tellerium compounds, or it can be combinations of multilayer stacks of different of the above layers combined. Alternatively, it can be phase change materials as e.g. GeSbTe, doped SbTe, or AsInSbTe. The trench 18 may be filled up with active material 13, after which the active material 13 may be partially removed, e.g. anisotropically etched, down to the etch stop layer 17 outside the trench 18, and down to the wordline WLᵢ present on or in the substrate 12 in the trench 18. This way, active material 13 is only present at the sidewalls of the trench 18, not at the bottom thereof and neither outside the trench 18. Thereafter, a layer of wordline material is provided in the trench, at least covering the layer of active material 13, and making electrical contact with the wordline WLₗ present at the bottom of the trench 18. Again this may be obtained by substantially completely filling the trench with wordline material, and etching this material back. This etch back is performed such that wordline material remains present covering the layer of active material 13, and such that some of the wordline material remains present at the bottom of the trench, so as to make an electrical contact to the wordline WLᵢ already present on or in the substrate 12, but such that a smaller trench is provided which can be filled with other material. In this smaller trench, a dielectric layer 14 is provided, covering the layer of wordline material. This may again be done by substantially completely filling the smaller trench with dielectric material, and partially removing the dielectric material from within the trench so as to provide a yet smaller trench. This latter trench is filled with control wordline material, and control wordline material is also provided on top of the stack.

After having filled the trench 18 with the stack of layers as described, a photoresist or hardmask 19 is provided over the structures obtained, as illustrated in top view in FIG. 18, for allowing etching of perpendicular stripes.

This photoresist or hardmask 19 is used for selectively etching control wordlines CWLᵢ, dielectric layer 14 and wordlines WLᵢ. The top etch stop layer 17 and the active layer 13 are not etched.

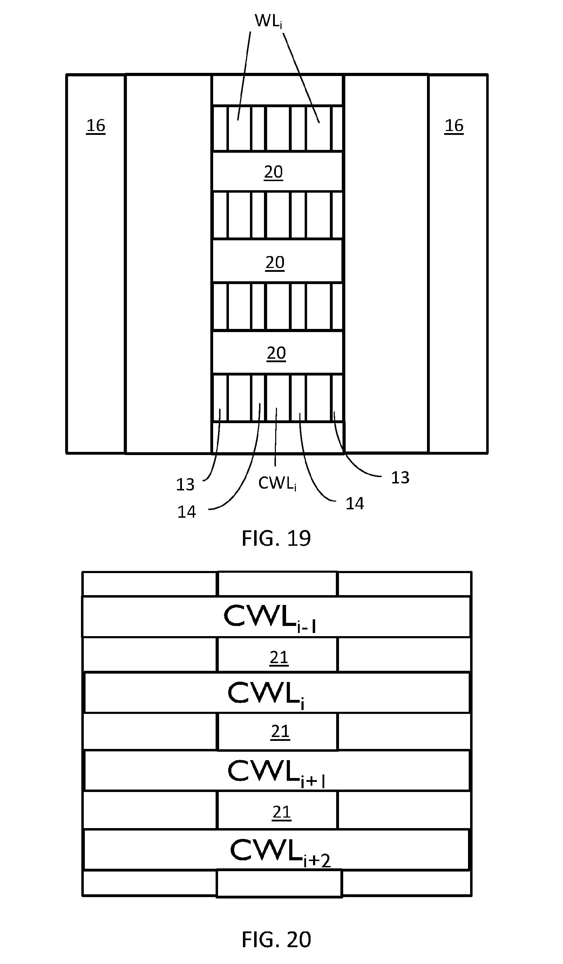

After the etching step, the stack, at the level A-A' as in FIG. 16, looks like illustrated in FIG. 19. This means that the filled up trench 18 is now cut by transversal trenches 20. These transversal trenches 20 are then filled with insulating material 21 such as e.g. SiO₂ (not illustrated in FIG. 19). In top view at the top, the obtained structure looks like FIG. 20, i.e. a plurality of control wordlines CWLi are provided, each underneath them connecting to control wordline material inside the former trench 18.

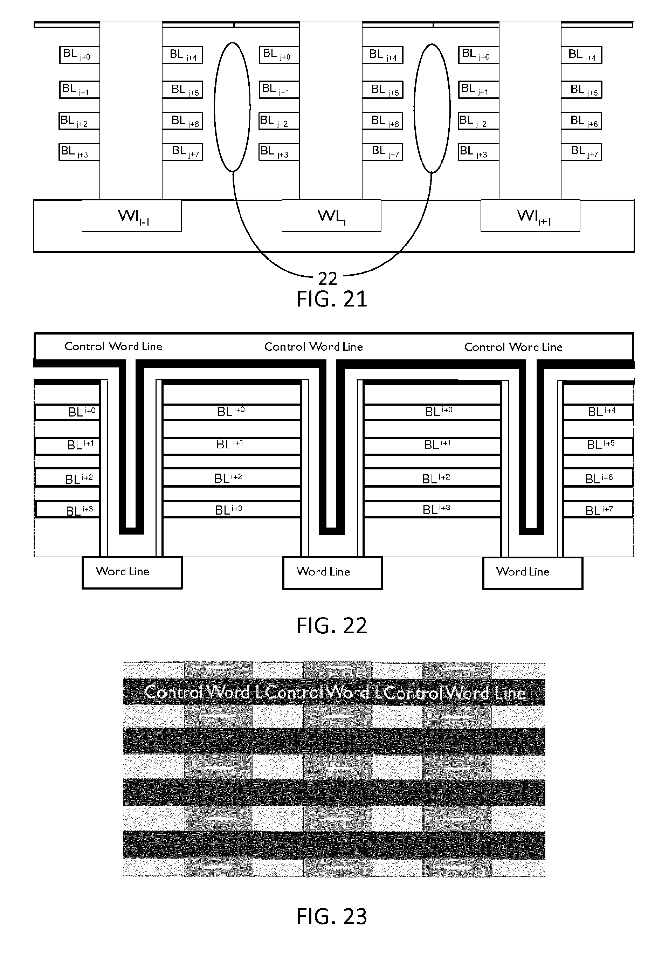

When forming a resistive memory array 10 according to embodiments of the present invention, a plurality of blocks as illustrated in FIG. 10 or in FIG. 12 can be placed adjacent one another. This results in a structure as in FIG. 21, the structure in FIG. 21 being illustrated for sake of ease without the trench being filled.

In an eighth embodiment, however, the bitlines BLⱼ between two different wordlines WLᵢ₋₁, WLᵢ, WLᵢ₊₁, i.e. at locations indicated with 22 in FIG. 21, do not need to be etched. Hence, in accordance with the eighth embodiment, a memory array 10 could look in vertical cross-sectional view like FIG. 22, or in top view like FIG. 23. This means that a same bitline is connected, via different resistive memory elements 11, to different adjacent wordlines WLᵢ, WLᵢ₊₁. This is not a problem if at any time at least one of the neighbouring wordlines WLᵢ, WLᵢ₊₁ is put in a non-conducting state. This can be obtained by biasing the control lines CWLᵢ.

The above 3D configurations have bitline planes substantially parallel to a major surface of a substrate, and vertical wordlines, substantially perpendicular to the major surface of the substrate. The manufacturing flow with trenches (seventh and eighth embodiments) has an advantage in scaling over plug versions (fifth and sixth embodiments) because in a plug version the width of the plug is determined in both dimensions of the cross-section by the thickness of the different filling layers, while in the trench version only one dimension (the one parallel to the trench width) is limited in scaling by this layer stack thickness, while the other dimension is only limited by patterning (litho + etch) and can be made potentially smaller resulting in a smaller cell area, hence a larger cell density. On the other hand, integration complexity of trench type arrays is increased because of the required etch through different materials.

In ninth and tenth embodiments, a 3D configuration is provided where bitlines are provided in vertical trenches, and wordlines are provided perpendicular thereto. This is illustrated in the following manufacturing flow.

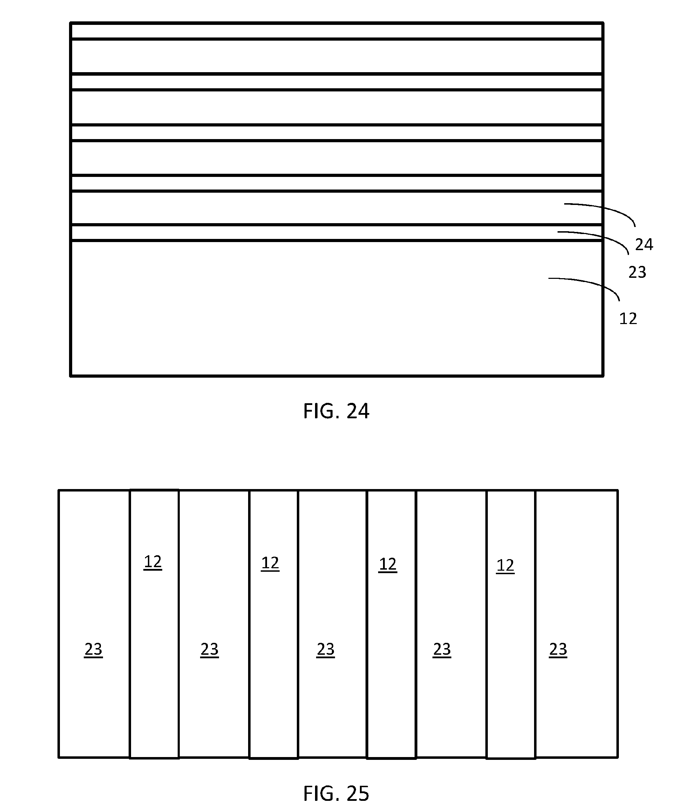

For embodiments in accordance with the ninth embodiment, first, as illustrated in FIG. 24, a substrate 12 is provided. The substrate 12 may be as in any of the previous embodiments. On top of the substrate, a layer stack of alternating layers of insulating material 23 such as for example SiO₂, and conductive material 24, such as for example metal or semiconductor material such as polysilicon, is provided. The conductive material 24 will function as wordlines.

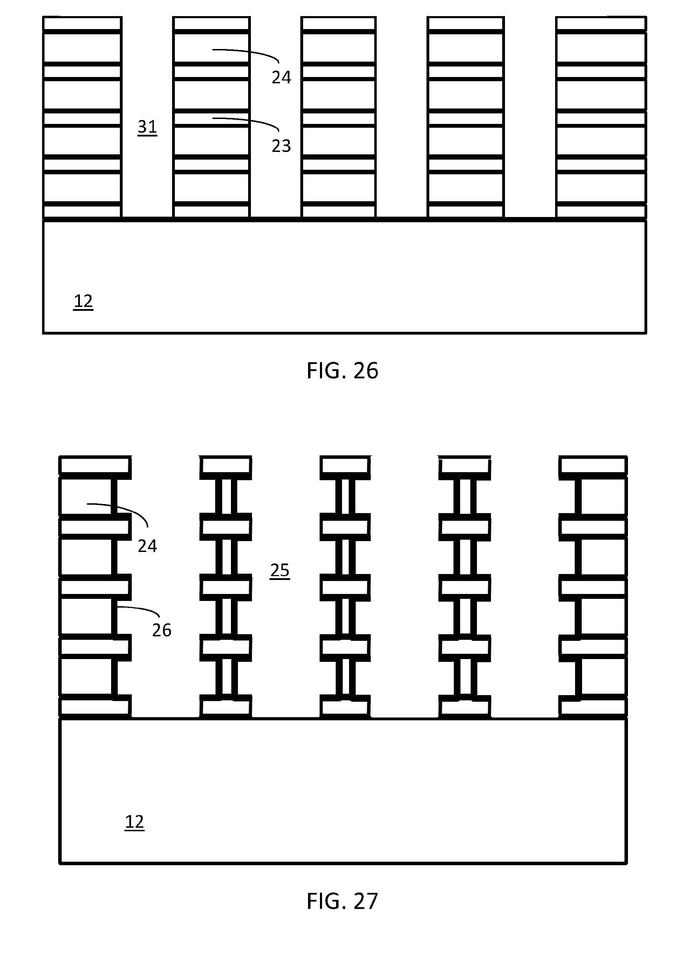

A plurality of trenches 31 are provided in the layer stack, as illustrated in top view in FIG. 25 and in vertical cross-sectional view in FIG. 26. Thereafter, the conductive material is recessed, i.e. pulled back in lateral direction, as illustrated in vertical cross-sectional view in FIG. 27. A thin layer of insulating material 26 is provided in the recesses, for example a layer of SiO₂ formed by oxidation of the polysilicon. This layer of insulating material 26 will later on serve as a gate dielectric.

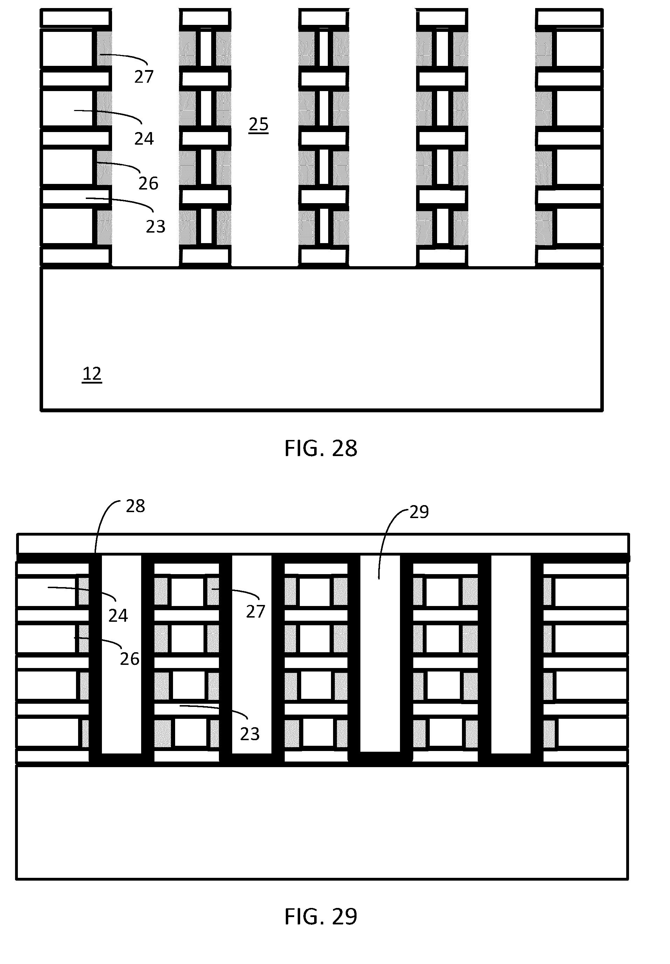

The formed recesses are then filled with conductive semiconductor material 27 of which the conductivity can be controlled by applying an electrical signal to a gate, such as for example polysilicon. This is illustrated in FIG. 28. This can be obtained by substantially completely filling the trenches 31 and formed recesses with conductive semiconductor material 27, and then etching the trenches 31 again, as such leaving the conductive semiconductor material 27, e.g. polysilicon, only in the recesses.

Thereafter, a layer of active material 28, i.e. a material capable of having its resistivity changed in response to an electrical signal, is provided all over the structure, for example by substantially completely filling the trenches 31 with active material 28 and then providing a smaller trench in the active material 28. The active material may be any of the suitable active materials mentioned with reference to the previous embodiments. The trench inside the active material 28 is then filled with conductive material for forming the bitlines 29. Any of the conductive materials used for forming bitlines in previous embodiments can also be used in this embodiment. This is illustrated in FIG. 29. Memory elements 11 are formed by the active material 28 between wordlines 27 and bitlines 29. At this moment in the process, a top view only shows bitline material everywhere.

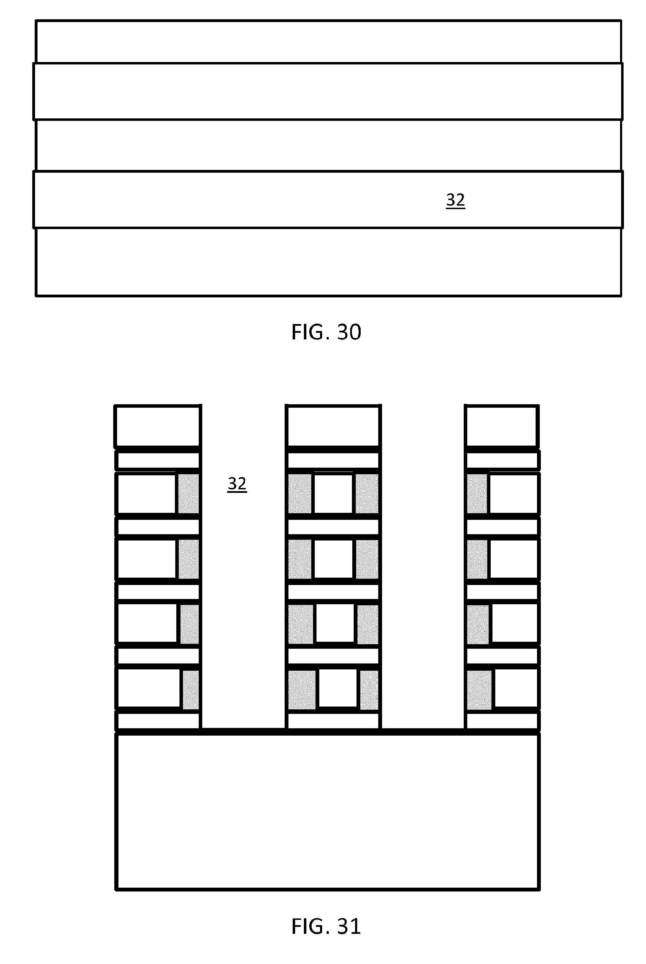

In a next step, the bitlines are formed. Hereto, trenches 32 are formed through the complete stack. This is illustrated in a top view of FIG. 29 after trench 32 formation in FIG. 30, and in a vertical cross-sectional view in a direction substantially perpendicular to the cross-sectional view of FIG. 29 in FIG. 31.

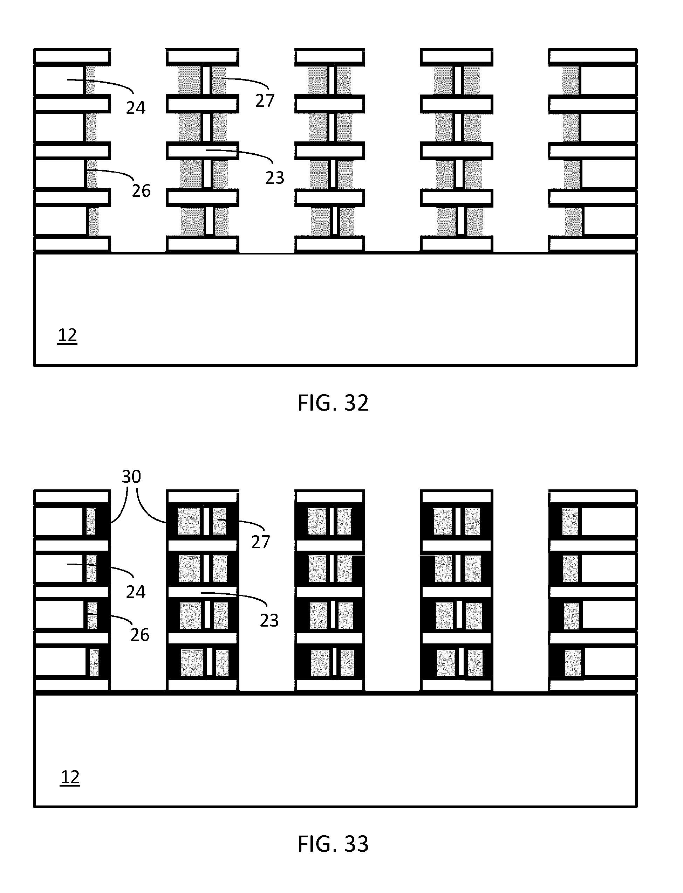

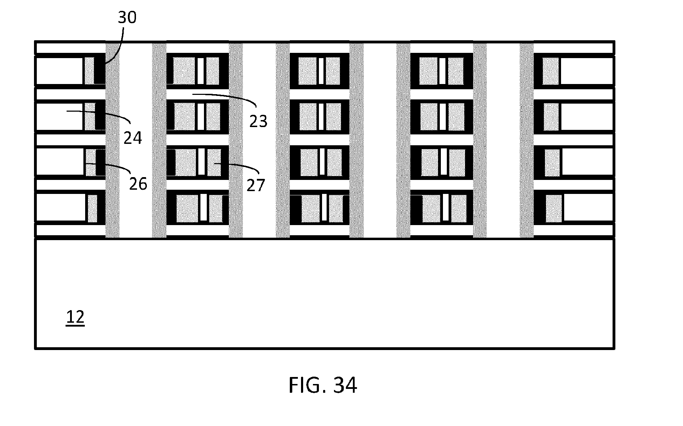

In an alternative embodiment, a tenth embodiment, of a 3D configuration where bitlines are provided in vertical trenches, and wordlines are provided perpendicular thereto, the start of the manufacturing process is up to the situation as illustrated in FIG. 28. Then the conductive semiconductor material 27 is recessed, as illustrated in FIG. 32. The formed recesses are filled with conductive material 30 such as TiN, which provides a better contact between the active material 28 to be provided and the wordlines 27. This is illustrated in FIG. 33. Thereafter, the manufacturing method continues as before, with provision of the layer of active material 28 and provision of the bitlines 29. The resulting structure is illustrated in FIG. 34.

Although all process flows are scalable, it is an advantage of this latter flow that it is more scalable than others.

In general it is an advantage of embodiments of the present invention that the wordlines are implemented as very long transistors. This alleviates the need for selectors in every cell, hence saving area and thus allowing memory arrays with higher density. It is an advantage of embodiments of the present invention that the wordlines are disappearing if not actuated, as they are pinched off by control wordlines.

While the invention has been illustrated and described in detail in the drawings and foregoing description, such illustration and description are to be considered illustrative or exemplary and not restrictive. The foregoing description details certain embodiments of the invention. It will be appreciated, however, that no matter how detailed the foregoing appears in text, the invention may be practiced in many ways. The invention is not limited to the disclosed embodiments.

## Claims

1. A resistive memory array (10), comprising
a plurality of resistive memory elements (11),
a plurality of first lines (WLᵢ) each associated with at least one resistive memory element (11), and arranged substantially in a first direction,
a plurality of second lines (BLⱼ) each associated with at least one resistive memory element (11), and arranged substantially in a second direction different from the first direction, and
a plurality of third lines (CWLᵢ) for controlling conductivity of the plurality of first lines (WLᵢ).

2. A resistive memory array (10) according to claim 1, wherein the plurality of third lines (CWLᵢ) are arranged in the first direction.

3. A resistive memory array (10) according to claim 2, wherein the plurality of third lines (CWLᵢ) overlay the plurality of first lines (WLᵢ) or vice versa.

4. A resistive memory array (10) according to any of the previous claims, wherein the first direction and the second direction are substantially orthogonal directions.

5. A resistive memory array (10) according to any of claims 1 to 3, wherein the first direction and the second direction are along circles and radii of these circles, respectively, or vice versa.

6. A resistive memory array (10) according to claim 1, wherein the plurality of third lines (CWLᵢ) are arranged orthogonally to the first lines (WLᵢ).

7. A resistive memory array (10) according to any of the previous claims, wherein any third line (CWLᵢ) is associated with one of the first lines (WLᵢ).

8. A resistive memory array (10) according to any of the previous claims, wherein a metal layer is provided between the resistive memory elements (11) and the first lines (WLᵢ).

9. A resistive memory array (10) according to any of the previous claims, the resistive memory array (10) being manufactured on a substrate having a major surface, wherein the first lines (WLᵢ) and the second lines (BLⱼ) are arranged parallel to the major surface.

10. A resistive memory array (10) according to claim 9, wherein a plurality of layers comprising first lines (WLᵢ) and the second lines (BLⱼ) are stacked in a direction perpendicular to the major surface.

11. A resistive memory array (10) according to any of claims 1 to 5 or 7 or 8, wherein the first lines (WLᵢ) are arranged parallel to the wafer surface, and the second lines (BLⱼ) are arranged substantially perpendicular to the major surface, or vice versa.

12. A method of manufacturing a resistive memory array (10), comprising
providing a plurality of resistive memory elements (11),
providing a plurality of first lines (WLᵢ) each associated with at least one resistive memory element (11), and arranged substantially in a first direction,
providing a plurality of second lines (BLⱼ) each associated with at least one resistive memory element (11), and arranged substantially in a second direction different from the first direction, and
providing a plurality of third lines (CWLᵢ) for controlling conductivity of the plurality of first lines (WLᵢ).

13. A method according to claim 12, wherein providing a plurality of first lines comprises providing the plurality of first lines in a plane parallel to a major surface of a substrate (12) and wherein providing a plurality of second lines comprises providing the plurality of second lines in a plane parallel to the major surface of the substrate (12).

14. A method according to claim 12, wherein providing a plurality of first lines comprises providing the plurality of first lines in a plane parallel to a major surface of a substrate (12) and wherein providing a plurality of second lines comprises providing the plurality of second lines substantially perpendicular to the major surface of the substrate (12).

15. A method according to claim 12, wherein providing a plurality of first lines comprises providing the plurality of first lines substantially perpendicular to the major surface of the substrate (12) and wherein providing a plurality of second lines comprises providing the plurality of second lines in a plane parallel to a major surface of a substrate (12).
